# FASCICULE DE BREVET EUROPEEN

(11) **EP 1 095 744 B1**
(45) Date de publication et mention de la délivrance du brevet: **21.01.2004**
(21) Numéro de dépôt: 00402846.0
(22) Date de dépôt: 16.10.2000
(51) Int. Cl.: B26D 7/01, B26D 7/26, B26F 1/02

(54) **Machine de poinconnage pour panneaux**
Maschine zum Lochen von Platten
Plates punching machine

(30) Priorité: 29.10.1999 FR 9913573
(43) Date de publication de la demande: 02.05.2001
(73) Titulaire: Automa-Tech, 27100 Val de Reuil (FR)
(72) Inventeur: Charbonnier, Serge, 27120 Chambray (FR)
(74) Mandataire: Dronne, Guy

(56) Documents cités:
- EP-A- 0 367 185
- EP-A- 0 819 504
- EP-A- 0 915 643
- DE-A- 4 219 004
- GB-A- 2 154 216
- US-A- 4 696 211
- US-A- 5 644 979

## Description

La présente invention a pour objet une machine de poinçonnage pour panneaux et notamment pour panneaux de circuits imprimés.

Il existe de plus en plus d'équipements utilisant des circuits imprimés de plus en plus complexes. Pour résoudre ce problème, on utilise couramment des circuits imprimés multicouches. Ces circuits muticouches consistent dans la réalisation d'un certain nombre de plaques ou panneaux de circuits imprimés élémentaires qui sont ensuite fixés entre eux avec de plus la réalisation de liaisons électriques entre les différentes couches afin d'obtenir le circuit imprimé multicouche complet.

Du fait que, lors de la réalisation du circuit complet, il est bien sûr nécessaire d'empiler avec une grande précision les circuits imprimés élémentaires afin de réaliser le circuit final, il est indispensable de prévoir dans chaque circuit imprimé élémentaire des moyens de repérage de position. Ce repérage est réalisé le plus souvent à l'aide de trous percés dans le support isolant du circuit imprimé à des emplacements parfaitement définis par rapport à la plaque et/ou au circuit imprimé qui est réalisé sur celle-ci.

En outre, il est bien connu qu'il est nécessaire pour des raisons économiques que la mise en oeuvre des différentes étapes de fabrication du circuit imprimé puisse être réalisée avec des machines à fonctionnement automatique.

La demande de brevet européen EP-A 819 504 décrit une machine de poinçonnage qui correspond au préambule de la revendication 1. Une telle machine permet effectivement l'alimentation automatique de la machine de poinçonnage ainsi que le positionnement de la plaque de circuit imprimé par rapport au bâti de la machine et, enfin, la mise en place des différents poinçons de cette machine pour réaliser les trous aux endroits désirés. Cependant, dans cette machine, le positionnement final précis des trous par poinçonnage est obtenu à l'aide d'une phase initiale de positionnement du panneau de circuit imprimé par rapport au bâti de la machine à l'aide d'une table mobile en X, Y et en rotation. Après le positionnement précis du panneau de circuit imprimé par rapport au bâti, celui-ci est immobilisé par des moyens mécaniques. Par ailleurs, dans cette machine le déplacement des poinçons a simplement pour but d'adapter la machine aux différentes dimensions de panneau de circuit imprimé et de position des trous de référence à réaliser dans ce panneau.

Il s'avère que, pour certains types de fabrication, le positionnement du panneau de circuit imprimé par rapport à la machine peut nécessiter un temps non négligeable du fait notamment des dimensions importantes du panneau à positionner. En outre, le maintien du panneau lors de l'opération de poinçonnage doit être réalisé avec une très grande précision tout en évitant les risques de flexion du panneau qui viendraient altérer la précision du positionnement du trou réalisé. Or, bien entendu, il est nécessaire d'avoir accès aux deux faces du panneau pour disposer de part et d'autre de celui-ci, d'une part, le poinçon proprement dit et, d'autre part, la matrice qui lui est associée.

En outre, les trous de positionnement ont souvent une forme qui n'est pas circulaire, mais oblongue, afin d'assurer une meilleure référence de positionnement. Il est donc nécessaire que la machine puisse non seulement réaliser les trous à l'emplacement voulu, mais qu'elle puisse réaliser des trous non circulaires avec une orientation correcte de ces trous par rapport au panneau.

De plus, pour permettre l'automatisation de ces machines, il est nécessaire que l'alimentation en panneaux puisse se faire par des moyens de transfert automatiques.

Enfin, les trous de positionnement doivent pouvoir être réalisés en tout point du panneau et, en particulier au centre de chaque côté du panneau. Cette possibilité ne doit pas entraîner une amplitude de déplacement du bloc de poinçonnage trop importante.

En effet, le porte-à-faux qui en résulterait risquerait d'être préjudiciable à la précision du positionnement final du poinçon.

Un objet de la présente invention est de fournir une machine de poinçonnage pour panneau et notamment pour panneau de circuit imprimé qui pallie les inconvénients des machines de l'état de la technique en permettant d'accroître la cadence de fonctionnement de la machine, notamment en simplifiant les opérations de positionnement final du panneau par rapport aux outils de poinçonnage.

Ce but est atteint par une machine ayant les éléments décrits dans la revendication 1.

On comprend que, selon l'invention, le panneau est fixe par rapport au bâti après son prépositionnement et que ce sont les blocs de poinçonnage qui sont positionnés avec précision en X, Y et en rotation pour obtenir la réalisation de trous aux emplacements prévus sur le panneau et avec l'orientation voulue. Il apparaît ainsi que le panneau étant fixe par rapport au bâti, il est possible de prévoir des moyens d'immobilisation du panneau par rapport au bâti qui sont plus efficaces et plus simples puisque ces moyens d'immobilisation sont fonctionnellement fixes par rapport au bâti.

De plus, le fait que les supports des blocs de poinçonnage d'au moins deux des blocs de poinçonnage soient en forme de portique, cela permet le passage des panneaux entre le poinçon et la matrice pour l'alimentation de la machine en panneaux et pour l'évacuation de ceux-ci après la réalisation des trous.

On comprend également qu'un prépositionnement des blocs de poinçonnage peut être réalisé avant leur positionnement final grâce à une détection préalable des marques représentatives de la position des trous effectuée sur le panneau dans la phase d'alimentation de la machine avec ces panneaux.

De préférence, les moyens optiques de comparaison de position comprennent une caméra solidaire de chaque bloc de poinçonnage.

Selon ce mode préféré de mise en oeuvre, du fait que la caméra est solidaire du bloc de poinçonnage et que celui-ci est prépositionné, la caméra peut avoir un champ réduit et donner une image plus précise.

De plus, il est possible, après la réalisation d'un trou par un outil de poinçonnage, de mesurer à l'aide de la caméra et de mémoriser l'erreur, à l'intérieur des tolérances admises, entre la position effective du trou réalisé et la marque correspondante sur le panneau de circuit imprimé. En calculant l'erreur moyenne pour les tous réalisés successivement par le même outil, on peut corriger, à l'aide de cette valeur moyenne, les instructions de déplacement transmises par le calculateur central de la machine au bloc de poinçonnage.

Cette opération, rendue possible par la maîtrise du positionnement précis de chaque bloc de poinçonnage en X, Y et en rotation, permet de s'affranchir de l'effet cumulé des tolérances de fabrication des différentes parties des outils de poinçonnage.

D'autres caractéristiques et avantages de l'invention apparaîtront mieux à la lecture de la description qui suit de plusieurs modes préférés de réalisation de l'invention donnés à titre d'exemples non limitatifs. La description se réfère aux figures annexées, sur lesquelles :
- la figure 1 est une vue en élévation de l'ensemble de la machine de poinçonnage ;
- la figure 2a est une vue de dessus d'un bloc de poinçonnage situé selon la direction d'introduction des panneaux ;
- la figure 2b est une vue de dessus du bloc de poinçonnage de la figure 2a ;
- la figure 3a est une vue en élévation d'un bloc de poinçonnage permettant le passage d'un panneau de circuit imprimé ;
- la figure 3b est une vue de dessus du bloc de poinçonnage de la figure 3b ; et
- la figure 4 est un schéma montrant les opérations de positionnement final de chaque bloc de poinçonnage.

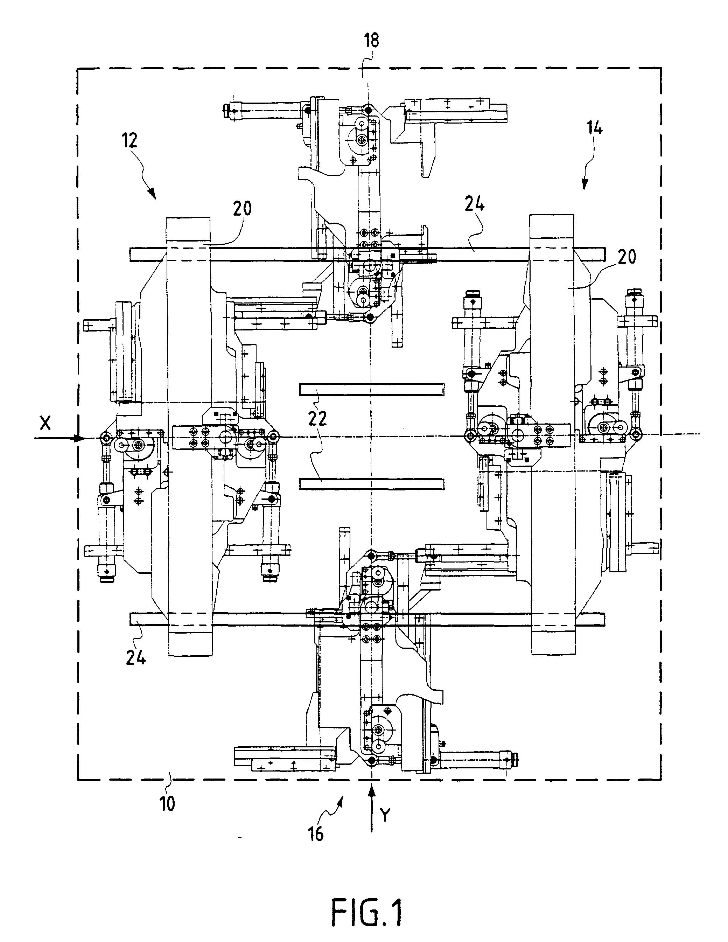

Sur la figure 1, on a représenté l'ensemble des différents éléments principaux de la machine de poinçonnage. La figure montre le bâti 10 de la machine et quatre blocs de poinçonnage mobiles respectivement référencés 12, 14, 16 et 18. Le bâti 10 est repéré par une direction X qui correspond à la direction d'introduction des panneaux de circuit imprimé dans la machine de poinçonnage et par une direction Y qui lui est orthogonale. Les blocs de poinçonnage 12 et 14 sont reliés au bâti 10 par l'intermédiaire de structures formant portique 20 afin de permettre le passage des panneaux de circuit imprimé. Sur cette figure, on a également représenté schématiquement des moyens d'entraînement 22 des panneaux pour les amener dans une position de prépositionnement par rapport à l'ensemble de la machine et des moyens de guidage et de maintien 24 des panneaux de circuit imprimé. Les moyens 24 consistent essentiellement dans deux ensembles permettant le pinçage des bords du panneau imprimé selon la direction X et l'application d'une tension entre ces éléments de pinçage pour assurer la planéité rigoureuse du panneau à traiter notamment pendant les opérations de poinçonnage. Le dispositif 24 est de préférence du type décrit en détail dans la demande de brevet européen EP-A- 915 643 qui doit être considérée comme faisant partie intégrante de la présente description. Les éléments de pinçage et de positionnement 24 peuvent être considérés en première approximation comme fixes par rapport au bâti. Cependant, ils présentent une possibilité de réglage selon la direction Y pour s'adapter aux différentes largeurs de panneau de circuit imprimé.

Comme on l'a déjà indiqué, la machine de poinçonnage comporte, de préférence, quatre blocs de poinçonnage, les blocs 12 et 14 qui comportent les structures 20 en forme de portique et qui sont disposées selon l'axe X de la machine et les blocs de poinçonnage 16 et 18 qui sont disposés selon la direction Y de la machine. Cependant, la machine pourrait comporter d'autres blocs de poinçonnage, de préférence analogues aux blocs 16 et 18 qui pourraient être solidaires en déplacement du bloc 16 ou 18 ou liés en déplacement à ces blocs.

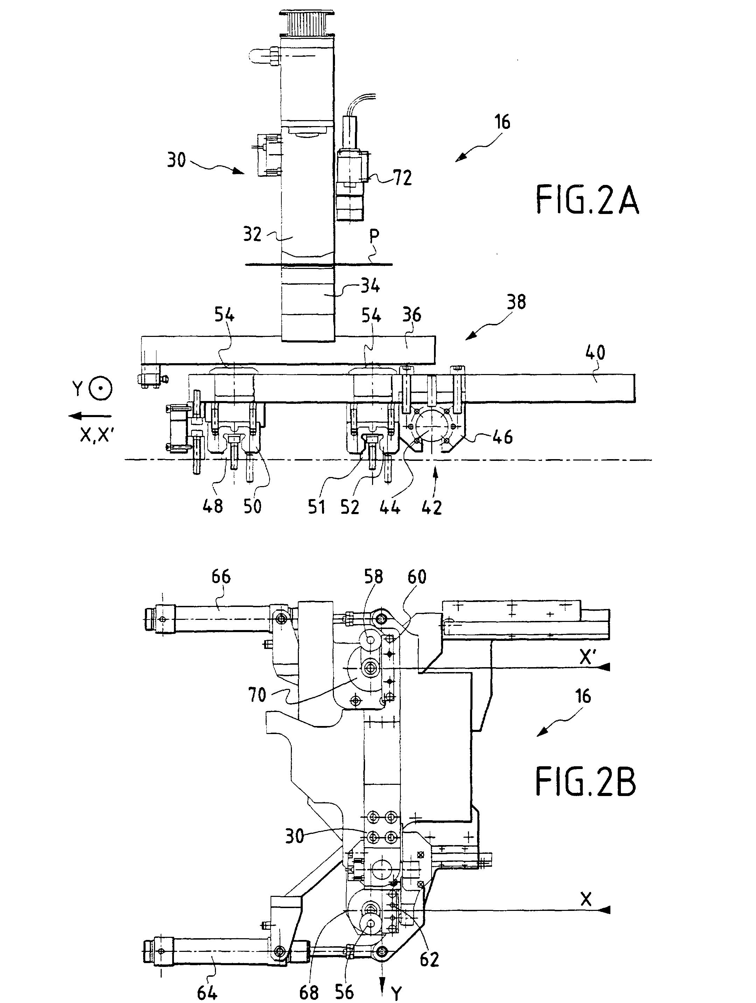

En se référant d'abord aux figures 2a et 2b, on va décrire les blocs de poinçonnage 16 et 18 qui sont identiques. On décrira, par exemple, le bloc 16. Les blocs de poinçonnage sont constitués essentiellement par un outil de poinçonnage 30 qui comprend essentiellement un porte-poinçon 32 et un porte-matrice 34, par un support 36 sur lequel est fixé l'outil de poinçonnage 30, et par des moyens de déplacement 38 qui permettent de déplacer le bloc de poinçonnage par rapport au bâti 10 selon les directions X et Y et en rotation autour de leur propre axe. La référence P symbolise la position du panneau de circuit imprimé.

L'outil de poinçonnage 30 avec son porte-poinçon 32 et son support de matrice 34 est de préférence du type décrit dans la demande de brevet européen EP-A- 819 504. La partie de la description de cette demande de brevet européen concernant le bloc de poinçonnage lui-même doit être considérée comme faisant partie intégrante de la présente demande de brevet.

Les moyens de déplacement 38 de l'outil de poinçonnage 30 sont essentiellement constitués par une table intermédiaire horizontale 40 qui est reliée au bâti par des moyens de déplacement selon la direction Y du bâti et reliée au support 36 du bloc de poinçonnage par des moyens de déplacement en X et en rotation qui seront décrits ultérieurement.

Les moyens de déplacement selon la direction Y interposés entre le bâti et la table 40 sont de préférence constitués par une vis à billes 42, la vis 44 étant montée rotative par rapport au bâti et entraînée en rotation par un moteur non représenté. L'écrou à billes 46 est lui solidaire de la face inférieure de la table 40. Les moyens de déplacement sont complétés par deux rails de guidage 48 et 50 solidaires du bâti 10 qui coopèrent avec des étriers 50 et 52 solidaires de la face inférieure de la table. Le support 36 repose sur la face supérieure de la table 40 par l'intermédiaire de systèmes à billes tels que 54. Ces systèmes à billes autorisent un libre déplacement du support 36 par rapport à la table 40 dans un plan horizontal avec un très faible frottement. Les déplacements du support 36 par rapport à la table 40 sont commandés par deux excentriques 56 et 58 qui sont montés sur la table 40 à deux extrémités de celle-ci selon la direction Y. Les excentriques 56 et 58 agissent sur deux butées mécaniques 60 et 62 qui sont solidaires du support 36. Les butées mécaniques 60 et 62 sont maintenues en contact contre les excentriques 56 et 58 par l'action de vérins 64 et 66. La mise en rotation des excentriques 56 et 58 est assurée par des moteurs non représentés entraînant en rotation les roues 68 et 70.

On comprend qu'ainsi, chaque extrémité du support 36 peut être déplacée séparément par rapport à la table intermédiaire 40 selon la direction X et X'. Cette double commande permet la commande en rotation de l'outil de poinçonnage 30 en plus de son déplacement en translation selon la direction X.

Comme le montre mieux la figure 2a, chaque bloc de poinçonnage est également équipé d'une caméra 72 qui est solidaire du bloc de poinçonnage et dont l'axe optique est dirigé vers le bâti pour fournir une image de la partie du panneau proche du bloc de poinçonnage portant la caméra.

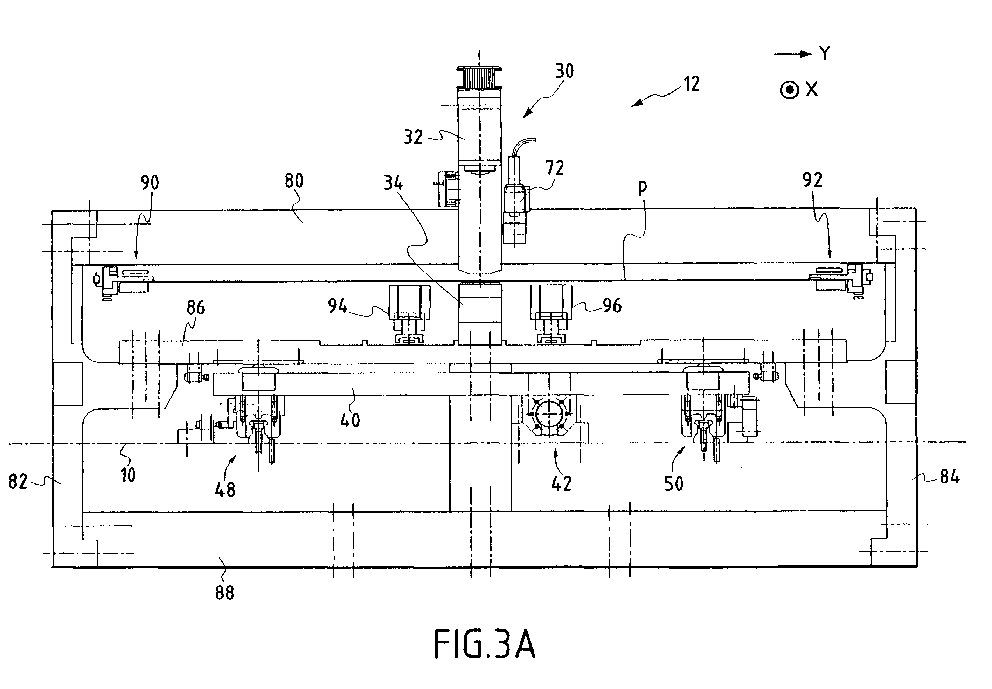

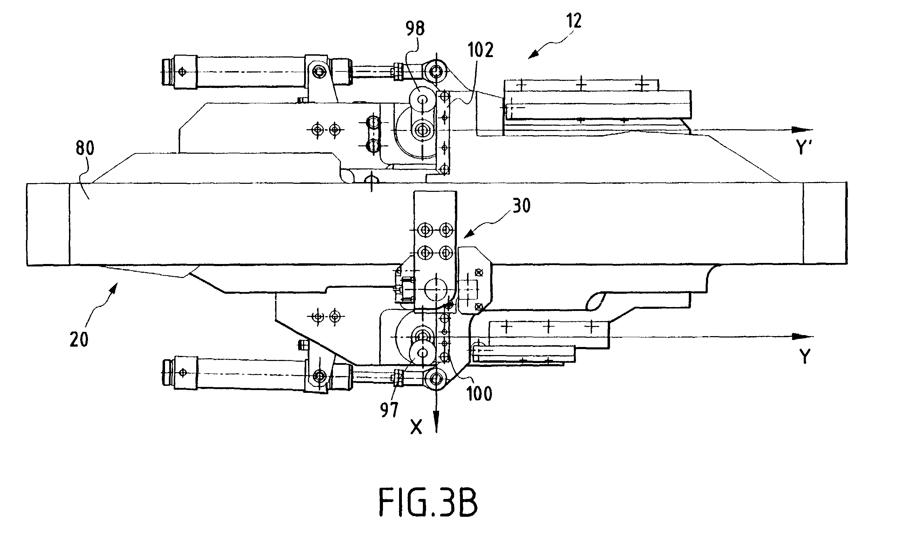

En se référant maintenant aux figures 3a et 3b, on va décrire un mode préféré de réalisation des blocs de poinçonnage 12 et 14 qui sont équipés des portiques 20. On décrira, par exemple, le bloc de poinçonnage 12.

Le bloc de poinçonnage 12 est très semblable au bloc de poinçonnage déjà décrit en liaison avec les figures 2 à l'exception de la forme de son support qui est constitué par une pièce en forme de portique. Plus précisément, cette pièce 20 est constituée par une poutre horizontale supérieure 80 solidaire de montants verticaux 82 et 84 ainsi que d'une traverse intermédiaire 86 et une traverse inférieure 88. Bien entendu, le bâti 10 a une structure ajourée permettant le déplacement de la structure en forme de portique 20. L'outil de poinçonnage 30 avec son porte-outil 32 et sa caméra associée 72 est solidaire de la poutre supérieure 80. Le support de matrice 34 est lui solidaire de la poutre intermédiaire 86 et disposé en regard du porte-outil de manière à laisser la place pour le passage du panneau de circuit imprimé P. Sur cette figure, on a représenté également schématiquement les deux ensembles de pinçage référencés 90 et 92 qui constituent le système de pinçage 24 de la figure 1, ces systèmes 90 et 92 étant bien sûr fonctionnellement reliés au bâti 10. On a également représenté les systèmes d'entraînement complémentaires 94 et 96 correspondant au dispositif d'entraînement 22 de la figure 1, ces dispositifs étant bien sûr également fonctionnellement solidaires du bâti 10.

Le déplacement du support 20 par rapport au bâti est réalisé par l'intermédiaire d'une table horizontale 40' fonctionnellement identique à la table 40. Le déplacement selon la direction X de la table 40' est obtenu à l'aide d'une vis à billes 42 identique à celle du bloc de poinçonnage 16. De même, le guidage de la table intermédiaire 40' lors de ce déplacement est obtenu par des rails solidaires du bâti 10 de même nature que les rails 48 et 50 du bloc de poinçonnage 16. La structure formant portique 20 est supportée par la table intermédiaire 40' par l'intermédiaire de systèmes à billes de même nature que les systèmes à billes 54 du bloc de poinçonnage 16 de telle manière que le portique 20 puisse se déplacer librement dans un plan horizontal par rapport à la table 40'. Plus précisément, les systèmes à billes 54 sont interposés entre la table intermédiaire 40' et la plaque 86.

Comme le montre mieux la figure 3b, les déplacements selon la direction Y et les déplacements en rotation du portique 20 sont réalisés à l'aide de systèmes identiques à ceux qui sont utilisés dans le bloc de poinçonnage 16. Ils sont constitués par deux excentriques 96 et 98 coopérant avec des butées 100 et 102 solidaires du portique 20, ces butées étant respectivement disposées aux deux extrémités du portique selon la direction X. Les excentriques 96 et 98 permettent donc de déplacer séparément les extrémités du portique 20 selon la direction X, ces déplacements étant réalisés selon les directions Y et Y', ce qui permet le réglage en rotation du portique et donc de l'outil de poinçonnage.

Il faut également souligner que la présence des deux portiques permet d'atteindre n'importe quel point du panneau sans que l'outil de poinçonnage présente un porte-à-faux significatif susceptible d'affecter la précision de son positionnement.

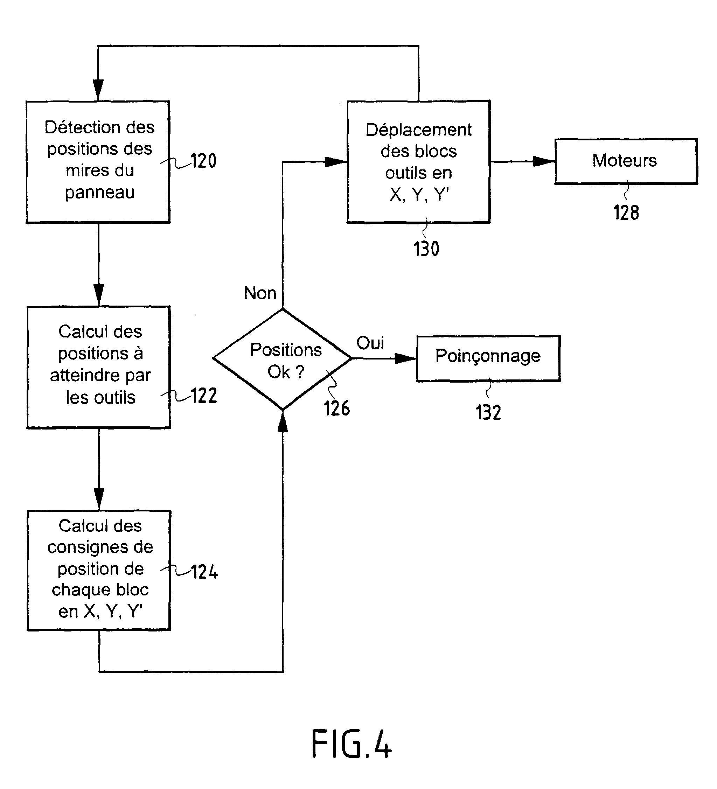

En se référant maintenant à la figure 4, on va décrire le fonctionnement de la machine de poinçonnage. Après que le panneau de circuit imprimé ait été amené sur le bâti et immobilisé par les systèmes de pincement 24, les caméras portées par chaque bloc de poinçonnage détectent la position de la mire du panneau correspondant au bloc de poinçonnage dans une étape 120. Le circuit de traitement associé à la machine calcule pour ce bloc de poinçonnage, dans l'étape 122, les positions à atteindre par l'outil de poinçonnage. Sur la base de ces informations, on calcule les consignes de position du bloc de poinçonnage en X, Y et en rotation dans l'étape 124. Ces positions sont comparées en 126 avec la position effective du bloc de poinçonnage, position qui est fournie par des capteurs de position du bloc non décrits en détail. Si la position est correcte pour l'ensemble des outils de poinçonnage, l'actionnement des poinçons des différents blocs est commandé à l'étape 128. Si la position n'est pas correcte, à l'étape 130, on commande les différents actuateurs 132 en X, Y et en rotation de chaque bloc de poinçonnage. La nouvelle position atteinte est comparée à la position calculée pour le bloc de poinçonnage concerné et le processus se répète jusqu'à ce que la position de chaque bloc soit correcte.

En variante, on pourrait prévoir que la détection des erreurs de position des blocs de poinçonnage soit réalisée par un ensemble de caméras liées au bâti, qui remplaceraient bien sûr les caméras embarquées sur les blocs de poinçonnage.

De plus, dans certains cas, il peut être intéressant qu'un bloc de poinçonnage comporte plusieurs outils de poinçonnage. Par exemple, les blocs de poinçonnage 12 et 14 pourraient comporter deux outils de poinçonnage supplémentaires disposés de part et d'autres de l'outil 30 sur les traverses 80 et 86.

Dans le mode préféré de réalisation selon lequel chaque bloc de poinçonnage comporte sa propre caméra, il est possible de mettre en oeuvre une auto-correction des instructions de déplacement du bloc de poinçonnage.

Après la réalisation de chaque trou par un même bloc de poinçonnage, la caméra est commandée pour prendre une image du trou effectivement réalisé et la marque sur le panneau indiquant la position théorique du trou à réaliser. A partir de cette image, le calculateur central de la machine détermine le décalage et calcule la valeur moyenne des décalages pour chaque bloc de poinçonnage. Cette valeur moyenne de décalage est utilisée pour corriger les instructions de déplacement transmises au bloc de poinçonnage à partir de l'erreur de position détectée par la caméra lors de la réalisation du trou ultérieur par le bloc de poinçonnage concerné.

## Revendications

1. Machine de poinçonnage d'un panneau sur lequel la position de chaque trou à réaliser est repérée par une marque, au moins certains des trous pouvant avoir un contour non circulaire, qui comprend :
- un bâti (10) pour recevoir ledit panneau, ledit bâti présentant des directions X et Y ;
- des moyens de transfert pour amener un panneau sur ledit bâti selon la direction X ;
- des moyens (24) d'immobilisation dudit panneau par rapport au bâti ;
- au moins quatre blocs de poinçonnage (12, 14, 16, 18), chaque bloc étant solidaire d'un support (20, 36), chaque bloc de poinçonnage comprenant au moins un outil porte-poinçon (32), et au moins un ensemble porte-matrice (34), le support de deux desdits blocs ayant la forme d'un portique pour permettre le passage desdits panneaux selon la direction X entre ledit outil porte-poinçon et ledit ensemble porte-matrice desdits deux blocs de poinçonnage, **caractérisée en ce qu'**elle comprend :
- des moyens (38) pour déplacer séparément par rapport au bâti chaque bloc de poinçonnage selon les directions X, Y et en rotation ;
- des moyens optiques (72) pour comparer la position de chaque bloc de poinçonnage avec la marque correspondante et pour élaborer des informations d'erreur de position en X, Y et en rotation chaque bloc de poinçonnage ; et
- des moyens (130, 132) pour commander séparément les moyens de déplacement en réponse aux informations d'erreur de position.

2. Machine de poinçonnage selon la revendication 1, **caractérisée en ce que** les moyens optiques de comparaison comprennent une caméra (72) solidaire de chaque bloc de poinçonnage.

3. Machine de poinçonnage selon l'une quelconque des revendications 1 et 2, **caractérisée en ce que** les moyens de déplacement de chaque bloc de poinçonnage (12, 14) associé à un support formant portique (20) comprennent une table intermédiaire (40), des moyens (42) pour déplacer ladite table intermédiaire par rapport au bâti (10) selon la direction X et deux moyens distincts (96, 98, 100, 102) pour déplacer deux zones distinctes du support formant portique (20) par rapport à ladite table intermédiaire selon la direction Y.

4. Machine selon l'une quelconque des revendications 1 à 3, **caractérisée en ce que** les moyens de déplacement de chacun des deux blocs de poinçonnage (16, 18) non associés à des supports formant portiques comprennent une table intermédiaire (40), des moyens (42) pour déplacer ladite table par rapport au bâti (10) selon la direction Y et deux moyens distincts (56, 58, 60, 62) pour déplacer deux zones distinctes du support du bloc-outil par rapport à ladite table intermédiaire selon la direction X.

5. Machine de poinçonnage selon l'une quelconque des revendications 3 et 4, **caractérisée en ce que** les moyens pour déplacer la table intermédiaire (40, 40') par rapport au bâti comprennent une vis à billes (42) disposée selon la direction X pour les blocs de poinçonnage associés à des supports en forme de portique et selon la direction Y pour les blocs de poinçonnage non associés à des supports en forme de portique, et des rails de guidage (48, 50) solidaires du bâti et parallèles à ladite vis.

6. Machine de poinçonnage selon l'une quelconque des revendications 3 à 5, **caractérisée en ce qu'**elle comprend en outre des systèmes à billes (54) interposés entre la face supérieure de chaque table intermédiaire (40, 40') et la face inférieure de chaque support (36, 20).

7. Machine selon la revendication 2, **caractérisée en ce qu'**elle comprend, en outre, des moyens pour, après la réalisation d'un trou par un bloc de poinçonnage (12, 14, 16, 18), commander la caméra (72) pour mesurer le décalage de position entre le trou effectivement réalisé et la marque sur le panneau et **en ce que** la machine comprend en outre des moyens pour calculer et mémoriser la valeur moyenne desdits décalages successifs pour un même bloc de poinçonnage et des moyens pour corriger les instructions transmises aux moyens de déplacement associés au bloc de poinçonnage en fonction dudit décalage moyen.

## Claims

1. A machine for punching a panel on which the position of each hole to be made is identified by a mark, at least some of the holes being capable of having an outline that is not circular, which comprises:
- a structure (10) for receiving said panel, said structure presenting X and Y directions;
- transfer means for bringing a panel onto said structure in the X direction;
- means (24) for holding said panel relative to the structure;
- at least four punch blocks (12, 14, 16, 18), each block being secured to a support (20, 36), each punch block comprising at least one punch carrier tool (32) and at least one die carrier assembly (34), the support for two of said blocks being in the form of a gantry to enable said panels to travel in the X direction between said punch carrier tool and said matrix carrier assembly of said two punch blocks, the machine being **characterised in that**:
- displacement means (38) for separately moving each punch block relative to the structure in the X and Y directions and in rotation;
- optical comparator means (72) for comparing the position of each punch block with the corresponding mark and for generating X and Y and rotation position error information relating to each punch block; and
- control means (130, 132) for separately controlling the displacement means in response to the position error information.

2. A punch machine according to claim 1, **characterised in that** the optical comparator means comprise a camera (72) secured to each punch block.

3. A punch machine according to claim 1 or 2, **characterised in that** the displacement means for each punch block (12, 14) associated with a support forming a gantry (20) comprise an intermediate table (40), means (42) for displacing said intermediate table relative to the structure (10) in the X direction, and two distinct means (96, 98, 100, 102) for displacing two distinct zones of the gantry-forming support (20) relative to said intermediate table in the Y direction.

4. A machine according to any one of claims 1 to 3, **characterised in that** the displacement means of each of the two punch blocks (16, 18) that are not associated with gantry-forming supports comprise an intermediate table (40), means (42) for displacing said table relative to the structure (10) in the Y direction, and two distinct means (56, 58, 60, 62) for displacing two distinct zones of the tool block support relative to said intermediate table in the X direction.

5. A punch machine according to claim 3 or 4, **characterised in that** the means for displacing the intermediate table (40, 40') relative to the structure comprise a ball screw system (42) disposed in the X direction for the punch blocks associated with gantry-forming supports and in the Y direction for the punch blocks not associated with gantry-forming supports, and guide rails (48, 50) secured to the structure and parallel to said screws.

6. A punch machine according to any one of claims 3 to 5, **characterised in that** it further comprises ball systems (54) interposed between the top face of each intermediate table (40, 40') and the bottom face of each support (36, 20).

7. A machine according to claim 2, **characterised in that** it further comprises means for controlling, after a hole has been made by a punch block (12, 14, 16, 18), the camera (72) so as to measure the position offset between the hole actually made and the mark on the panel, and **in that** the machine further comprises means for calculating and storing the mean value of said successive offsets for a given punch block and means for correcting the instructions transmitted to the displacement means associated with the punch block as a function of said mean offset.

## Patentansprüche

1. Maschine zum Lochen einer Platte, auf der die Stellung jedes auszuführenden Lochs durch eine Markierung bezeichnet ist, wobei mindestens einzelne der Löcher einen nicht kreisförmigen Umriss haben können, mit:
- einem Gestell (10) zum Aufnehmen der Platte, wobei das Gestell Richtungen X und Y aufweist,
- Transportmitteln, um eine Platte in der Richtung X auf das Gestell zu bringen;
- Mitteln (24) zum Festhalten der Platte in Bezug auf das Gestell,
- mindestens vier Stanzblöcken (12, 14, 16, 18), von denen jeder Block an einem Träger (20, 36) befestigt ist, wobei jeder Stanzblock mindestens ein Stempelhaltewerkzeug (32) und mindestens eine Matrizenhalteanordnung (34) aufweist, der Träger von zweien der Blöcke die Form eines Portals hat, um den Durchgang der Platten in der Richtung X zwischen dem Stempelhaltewerkzeug und der Matrizenhalteanordnung zuzulassen,
**dadurch gekennzeichnet, dass** sie umfasst:
- Mittel (38), um jeden Stanzblock in Bezug auf das Gestell gesondert in den Richtungen X, Y und durch Drehen zu bewegen,
- optische Mittel (72), um die Stellung jedes Stanzblocks mit der entsprechenden Markierung zu vergleichen und Informationen über X-, Y- und Drehstellungsfehler jedes Stanzblocks zu gewinnen, und
- Mittel (130,132), um die Bewegungsmittel in Reaktion auf Informationen über Stellungsfehler getrennt zu steuern.

2. Maschine zum Lochen nach Anspruch 1, **dadurch gekennzeichnet, dass** die optischen Mittel zum Vergleichen eine Kamera (72) aufweisen, die an jedem Stanzblock befestigt ist.

3. Maschine zum Lochen nach einem der Ansprüche 1. und 2, **dadurch gekennzeichnet, dass** die Mittel zum Bewegen jedes Stanzblocks (12, 14), der einem portalförmigen Träger (20) zugeordnet ist, einen Zwischentisch (40) aufweisen, sowie Mittel (42) zum Bewegen dieses Zwischentisches in Bezug auf das Gestell (10) in Richtung X und zwei gesonderte Mittel (96, 98, 100, 102), um zwei gesonderte Bereiche des portalförmigen Trägers (20) in Bezug auf den Zwischentisch in der Richtung Y zu bewegen.

4. Maschine nach einem der Ansprüche 1 bis 3, **dadurch gekennzeichnet, dass** die Mittel zum Bewegen jedes der beiden Stanzblöcke (16, 18), die keinem der portalförmigen Träger zugeordnet sind, einen Zwischentisch (40) aufweisen sowie Mittel (42) zum Bewegen dieses Tisches in Bezug auf das Gestell (10) in der Richtung Y und zwei gesonderte Mittel (56, 58, 60, 62) zum Bewegen zweier gesonderter Bereiche des Trägers des Werkzeugblocks in Bezug auf den Zwischentisch in der Richtung X.

5. Maschine zum Lochen nach einem der Ansprüche 3 und 4, **dadurch gekennzeichnet, dass** die Mittel zum Bewegen des Zwischentisches (40, 40') in Bezug auf das Gestell eine Kugelumlaufspindel (42) aufweisen, die bei den je einem der portalförmigen Träger zugeordneten Stanzblöcken in der Richtung X angeordnet ist, und bei den keinem der portalförmigen Träger zugeordneten Stanzblöcken in der Richtung Y angeordnet ist, sowie Führungsschienen (48, 50), die am Gestell befestigt und zu der genannten Spindel parallel sind.

6. Maschine zum Lochen nach einem der Ansprüche 3 bis 5, **dadurch gekennzeichnet, dass** sie außerdem Kugelsysteme (54) aufweist, die zwischen der Oberseite jedes Zwischentisches (40, 40') und der Unterseite jedes Trägers (36, 20) angeordnet sind.

7. Maschine nach Anspruch 2, **dadurch gekennzeichnet, dass** sie außerdem Mittel umfasst, um nach dem Ausführen eines Lochs durch einen Stanzblock (12, 14, 16, 18) die Kamera (72) zu steuern, um den Stellungsversatz zwischen dem tatsächlich ausgeführten Loch und der Markierung auf der Platte zu messen, und dass die Maschine ferner Mittel aufweist, um den Mittelwert der aufeinanderfolgenden Versätze für einen und den selben Stanzblock zu berechnen und zu speichern, sowie Mittel, um die dem Stanzblock zugeordneten Verstellmitteln übermittelten Anweisungen in Abhängigkeit vom mittleren Versatz zu korrigieren.
